# EUROPÄISCHE PATENTSCHRIFT

(11) **EP 0 371 197 B1**
(45) Veröffentlichungstag und Bekanntmachung des Hinweises auf die Patenterteilung: **21.12.1994**
(21) Anmeldenummer: 89112924.9
(22) Anmeldetag: 14.07.1989
(51) Int. Cl.: G01S 17/88, G01S 7/48, H01L 27/148

(54) **Bildsensor**
Image sensor
Capteur d'image

(30) Priorität: 23.11.1988 DE 3839512
(43) Veröffentlichungstag der Anmeldung: 06.06.1990
(73) Patentinhaber: TEMIC TELEFUNKEN microelectronic GmbH, 74072 Heilbronn (DE)
(72) Erfinder: Spies, Hans, D-8068 Pfaffenhofen (DE); Wöhrl, Alfons, D-8898 Schrobenhausen (DE); Spies, Martin, D-8068 Pfaffenhofen 1 (DE)
(74) Vertreter: Maute, Hans-Jürgen, Dipl.-Ing.

(56) Entgegenhaltungen:
- EP-A- 0 269 902
- DE-A- 3 829 003
- GB-A- 2 194 390
- BILD DER WISSENSCHAFT, Oktober 1988, Seiten 134-135, Deutsche Verlags-Anstalt, Stuttgart, DE; "Prometheus - Steuermann durch den Verkehr von morgen"

## Beschreibung

Die Erfindung betrifft einen Bildsensor gemäß dem Oberbegriff des Patentanspruchs 1.

Es sind Bildsensoren auf der Basis von Halbleiterelementen vielfach bekannt. Ein Übersichtsartikel ist z.B. In Elektronik-Praxis Nr. 9, September 1978, Seiten 12 ff. enthalten. Es handelt sich bei den Bildsensoren um Schaltungen, bei denen höchste Integratlonsfählgkeit wichtig ist und bei der deshalb große Anforderungen an die Herstellungstechnologie zu stellen sind. Dies gilt insbesondere dann, wenn die Ausgangssignale, die in dem Sensor z.B. nach Einfallen einer Strahlung abgegeben werden können, nur sehr klein sind.

Aufgabe der Erfindung ist es, einen Bildsensor zu schaffen auf Halbleiterbasis, der eine wesentlich höhere Ausbeute (Signal-Rauschabstand) bzw. ein gesteigertes Nutzsignal erbringt und auf einfache Weise steuerbar ist.

Gelöst wird diese Aufgabe durch einen Bildsensor, dessen fotoempfindliches Element auf Halbleiterbasis, wie CCD-Element oder Elementenanordnung, durch Erzeugen eines Avalanche-Effektes in einer Schicht optisch steuerbar ist.
Durch die Ausnützung des Avalanche-Effektes bzw. einer flächenhaften Avalanche-Diode an einem CCD-Sensor wird eine Empfindlichkeitserhöhung des Sensorelementes um das 100-fache erreicht.

Weitere Merkmale und Vorteile der Erfindung sind den weiteren Ansprüchen, sowie der Beschreibung und Zeichnung von Ausführungsbeispielen zu entnehmen.

Es zeigen:
Fig. 1 den Aufbau des optischen Gesamtsystems in einer ersten Anwendung,
Fig. 2 einen optischen Empfänger einer ersten Art,
Fig. 3 ein Empfangselement (CCD-Element) zu Fig. 2,
Fig. 4 ein Empfangselement anderer Art, abgewandelt gegenüber Fig. 3,
Fig. 5 ein CCD-Element weiter abgewandelter Art,
Fig. 6 ein Empfänger, bei dem ein CCD-Element nach Fig. 5 anwendbar ist,
Fig. 7 eine gegenüber Fig. 5 abgewandelte Ausführung, anwendbar in der Anordnung nach Fig. 6,
Fig. 8 ein Diagramm von Signalfolgen zu einem Element nach Fig. 7,
Fig. 9 ein Blockschaltbild für einen optisch steuerbaren Bildsensor und eine Anwendung hierfür.

Die Erfindung wird nachstehend anhand von Ausführungsbeispielen erläutert, ohne hierauf beschränkt zu sein. Sie umfaßt selbstverständlich auch Abwandlungen und Kombinationen von beanspruchten, beschriebenen und dargestellten Merkmalen.

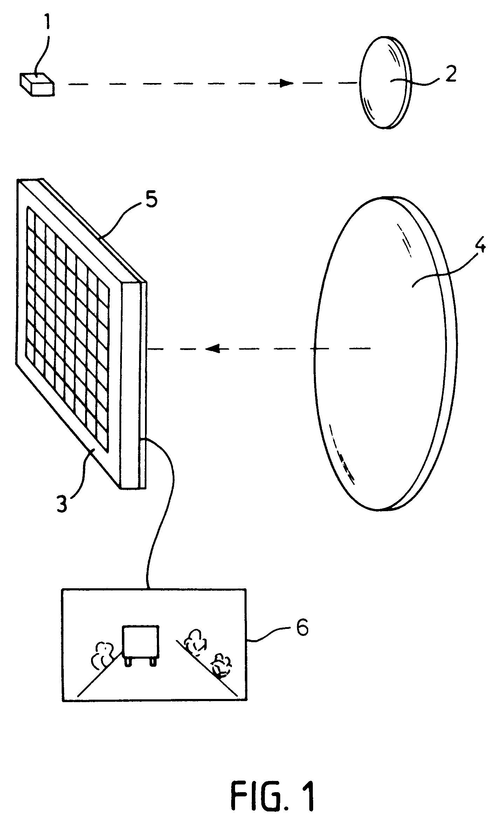

Wie Fig. 1 zeigt, läßt sich ein Bildsensor flächenhafter Ausführung in Halbleiterbauweise als CCD-Array so gestalten, daß er zusammen mit einer Empfangsoptik den Empfänger des Systems bildet, während ein Laser-Sender und eine Sendeoptik die optische Strahlung aussenden, die empfangen wird, um Abbildungen z.B. auf einer Straße vorausblickend von einem Kraftfahrzeug aus zu erlangen, bei dem ebenfalls Laser-Strahlen zur Abstandsmessung zu Hindernissen und/oder vorausfahrenden Fahrzeugen ausgesendet, empfangen und ausgewertet werden.

Der Sender ist mit 1, die Sendeoptik mit 2, der Empfänger als CCD-Array 3 ausgebildet und die Empfangsoptik mit 4 bezeichnet. Eine Abbildung wie vom Sensor gewonnen ist direkt unter diesem verkleinert in 6 dargestellt. Die Auswerteschaltung und Auswertemittel sind an sich bekannter Art und deshalb nicht dargestellt und auch nicht näher erläutert.

Neu und erfindungswesentlich ist, daß auf einer Fläche 5 des CCD-Sensors auf der Rückseite des Halbleiters in den Strahlung einfällt, eine Avalanche-Diode aufgebracht ist. Dies wird durch Implantieren einer geeigneten Beschichtung auf der Rückseite des CCD-Chips erreicht. Die Herstellungstechnologie kann auf verschiedene Weise ausgeführt werden. Die Materialien zum Implantieren bzw. Dotieren sind ebenfalls bekannter Art.

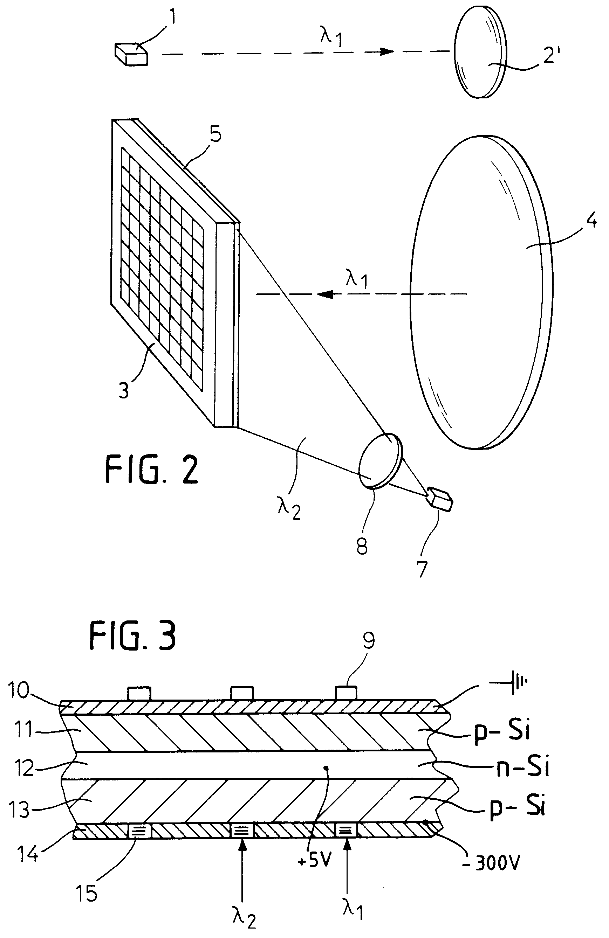

Fig. 2 zeigt als Detail des Gesamtsystems ein CCD-Array 3 mit Empfangsoptik 4, abweichend von der herkömmlichen CCD-Halbleiterelementanordnung, bei dem eine Fläche 5 als Avalanche-Diode und steuerbarer Verschluß dient, z.B. kann ein Halbleiter-Laser 7 mit eigener Optik 8 zum Steuern verwendet werden mit einer Gating-Wellenlänge λ 2 zwischen bevorzugt 1400 nm bis etwa 1800 nm. Wichtig ist, daß diese Ansteuerwellenlänge ausreichend unterschieden werden kann von der Meßwellenlänge λ 1 des einfallenden Lichtes, insbesondere 800 - 950 nm, wie sie bei Halbleiter-Lasern zum Entfernungsmessen angewandt wird.

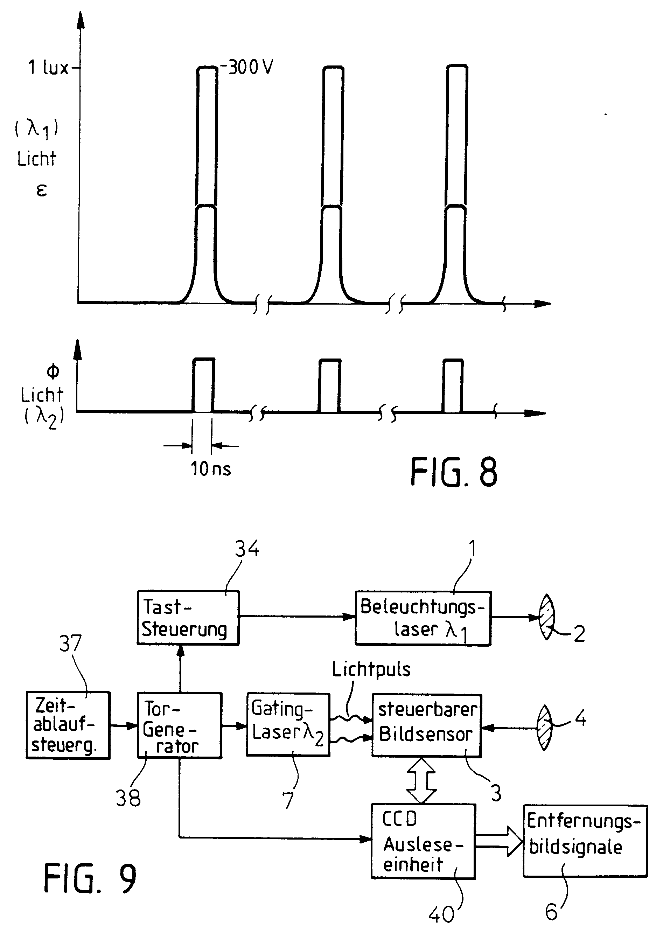

Die Ansteuerung des Halbleiter-Lasers für das Gating ist in einem Ausführungsbeispiel in Fig. 8 gezeigt. Geometrisch ist eine Ausführung und Anwendung in Fig. 3 gezeigt, insbesondere für den genannten optischen Verschluß, wie Belichtungssteuerung. Dabei ist die Schichtfolge des CCD-Halbleiters 3: p-n-p mit den Schichten 11 = p-Si, 12 = n-Si, 13 = p-Si und strukturierten Ausleseelektroden 9 auf der obersten oder Ground-Elektrodenschicht 10.

Auf die in Fig. 3 unterste Schicht 14 erfolgt die Einstrahlung λ1 und λ2 in diesem Beispiel von unten und es wird eine Spannung von bis etwa -300V angelegt, an die im mittleren Bereich ausgebildete n-Schicht eine Spannung von etwa + 5 V. Die einfallende Strahlung kann dann wie in der Zeichnung Fig. 3 ersichtlich durchgelassen werden (an Fenstern 15) oder mittels Avalanche-Effekt (in der Avalanche-Diodenschicht 14) durchsteuerbar und dann ggfs. an den Elektroden auslesbar sein, wie z.B. in der DE 38 17 153 A1 beschrieben oder gemäß dem Blockschaltbild nach Fig. 9, je nachdem, ob infolge Vorliegens oder Nichtvorliegens von Gating- oder Shutting-Lichtimpulsen des Steuerlasers 7 ein Raumladungstransport erfolgt, d.h. ein Transfer von gesammelten Ladungsträgern, wie Löchern oder Elektronen, je nachdem ob (+) oder (-).

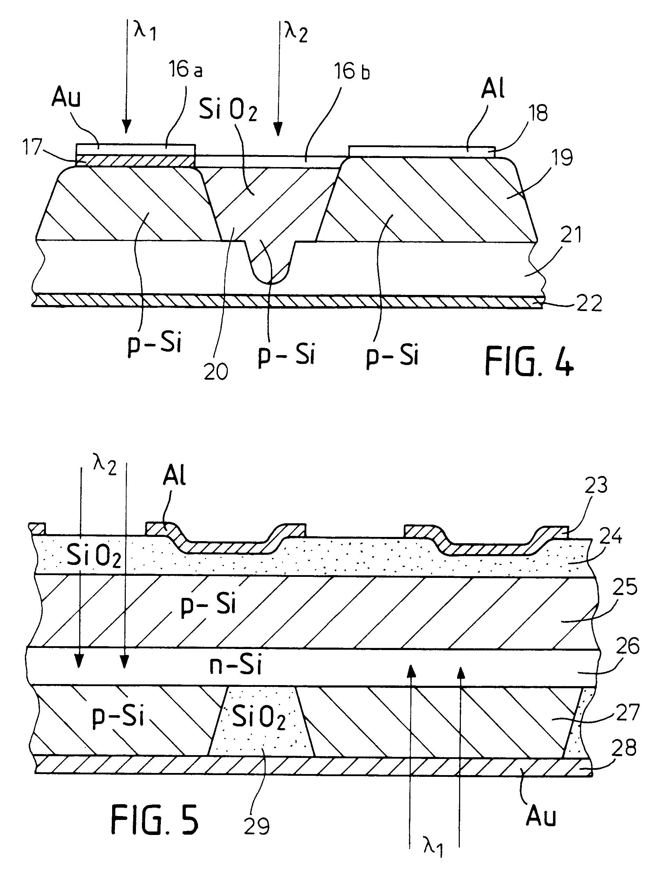

In Fig. 4 ist die Ausführung so getroffen, daß nicht auf der Rückseite des Strahlungseinfalls die Ausnutzung des Avalanche-Effektes wie in Fig. 3 erfolgt, sondern im Gegenteil seitlich, d.h. in Fig. 4 horizontal nebeneinander, erfolgt. Dabei ist auf einem transparentem oder semitransparenten Substrat 22 eine hochohmige nSi-Schicht 21 und darauf eine CCD-Struktur im horizontal und im Querschnitt gesehenen mittigen Bereich abgeschieden. In Fig. 4 von oben aus ist kegelförmig nach unten in durchgehenden Bereichen insbesondere transparentes SiO₂ 20 über pSi 19 und zwischen nSi 21 in der untersten Schicht auf dem Substrat 22 eingebettet. Die CCD-Struktur ist aus pSi über der in Fig. 4 rechts angeordneten Auslesestruktur, insbesondere Elektrodenstruktur 18 wie Aluminium-Elektroden o.ä., aufgebracht.

Auf der in Fig. 4 linken Seite ist eine dünne Schicht 17 aus transparentem Werkstoff, wie Gold, aufgebracht und bevorzugt eine oder mehrere Filterschichten 16a für die zu messende einfallende Strahlung insbesondere von reflektiertem Licht mit der Wellenlänge λ1. Hiervon verschieden ist die Strahlung für das Gating bzw. Ansteuern des Verschlusses 5 mit der Wellenlänge λ2, wobei über dem SiO₂ noch eine zweite Filterschicht 16b angeordnet sein kann.

Eine weitere Ausführung eines optisch steuerbaren Bildsensors ist in Fig. 5 ersichtlich. Es handelt sich hierbei wiederum um eine Einzeldarstellung eines halbleitenden Elementes im Querschnitt, wobei der Aufbau und die Schichtenfolge deutlich wird. Über einer Goldschicht 28, die die Einstrahlungsseite für die Bildinformation abgibt, in Fig. 5 unten, ist pSi bei 27 aufgebracht. Hierüber folgt wieder nSi bei 26 sehr hochohmig und darauf wieder pSi bei 25. Abweichend gegenüber Fig. 4 ist jedoch in der unteren pSi-Schicht SiO₂ oder dergleichen Material bei 29 zwischen einzelnen pSi-Bereichen jeweils lateral beabstandet angeordnet.

Die Anordnung ist mit Vorteil so getroffen, daß die Einstrahlung des reflektierten Lichtes λ1 für die Bildinformation nicht vertikal unterhalb der Einfallsrichtung des Verschluß-Steuerlichtes mit λ2 liegt, sondern seitlich nebeneinander. Anders als bei der Ausführung nach Fig. 3 erfolgt das Einstrahlen des Steuerlichts von dem pulsierenden Laser 7 in Fig. 5 von der Oberseite her, um eine Raumladung konzentriert in der n-Si-Schicht des Halbleiterelements Infolge ihrer Hochohmigkeit zu erzeugen. An die nSi-Schicht 26 ist wiederum eine unterschiedliche Spannung im Verhältnis zur pSi-Schicht 25 angelegt. Auf der Oberseite ist über der pSi-Schicht 25 eine transparente oder semitransparente Schicht 24 bevorzugt aus SiO₂ aufgebracht, auf der in Maskentechnik, insbesondere nach fotolithographischem Verfahren, die Ausleseelektronenstruktur 23 insbesondere mit Aluminium- oder Goldelektroden o.ä. in Form von Parallel-Bahnen aufgebracht ist (vgl. DE 38 17 153 A1).

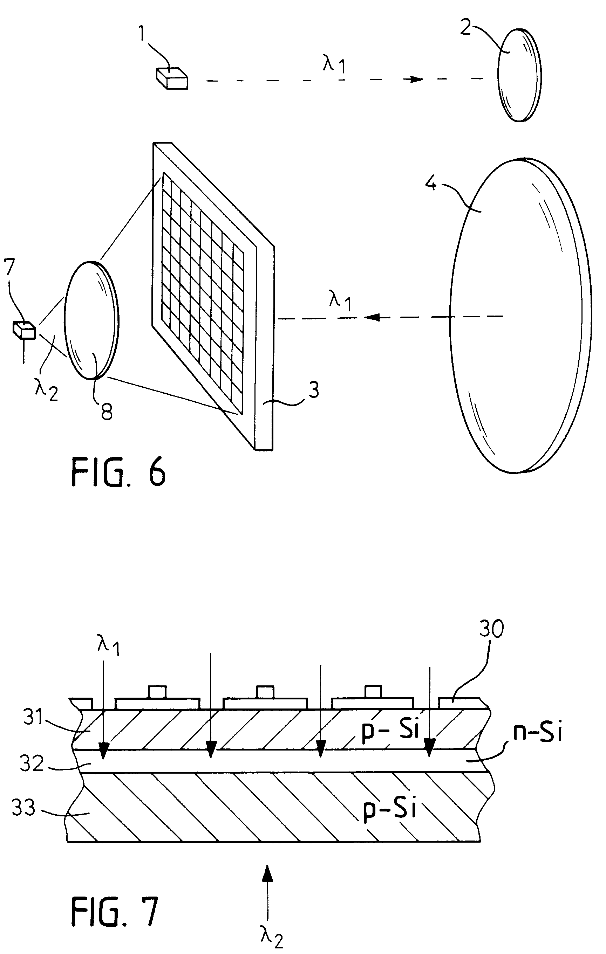

Eine andere Ausführung ist in Fig. 6 dargestellt. Hier kann die Bildauswertung im Empfangsteil anders gestaltet sein und insbesondere für eine automatische Fahrzeugführung in gegenseitigem, vorbestimmtem Abstand (im Convoy) siehe "Funkschau" 14/1988 Seite 42 pp, mit Vorteil angewandt werden. Dabei wird im Empfangsteil mit Sendeoptik und Empfangsoptik für die Verschluß-Steuerung mit λ2-Licht ein gepulster oder Tastlaser 7 mit Optik 8 verwandt, der auf der der reflektierten Meßlicht-Strahlung abgekehrten Seite des CCD-Arrays 3 angeordnet ist. Der Sendelaser 1 kann für die Szenenbeleuchtung wiederum die Meßwellenlänge λ1 mit Hilfe der Sendeoptik 4 erzeugen, die für die Abbildung und automatische Lenkung bzw. Führung eines Fahrzeuges geeignet ist.

Ein Querschnitt durch ein CCD-Element für die Anordnung nach Fig. 6 ist in Fig. 7 dargestellt, wobei der Grundaufbau wiederum die p-n-p-Folge der Schichten 31, 32, 33 ist. Die einfallene Meßlichtstrahlung λ1 kommt in Fig. 7 von oben und die Metallausleseelektroden 30 sind bei dieser Ausführung ebenfalls oben strukturiert angeordnet und in Maskentechnik insbesondere auf photolithogrphischem Wege aufgebracht.

In Fig. 8 ist eine Signalfolge dargestellt, die zum besseren Verständnis der Funktion hier angeführt ist. Im oberen Teil ist die bei λ1 reflektierte Meßlichtstrahlung ε aufgetragen mit einer austretenden Meßlichtstärke bis etwa 1 lux infolge Verstärkung bei Anlegen einer negativen Spannung bis 300 V und Auftreten eines Avalanche-Effekts. Im unteren Teil des Diagramms ist der Lichtstrom oder Lichtfluß Phi φ vom Steuerlaser 7 für das Gating oder Shutting dargestellt und dessen zeitliche Tastung. Die Tastimpulse liegen z.B. im Bereich von 10 ns und kleiner. Selbstverständlich sind geeignete Tastungen oder Taktungen oder Pulsfolgen oder Modulation möglich (z.B. Pulscodemodulation oder Pulsdauermodulation).

In Fig. 9 ist ersichtlich einerseits der Beleuchtungslaser 1, andererseits der Steuerlaser 7 für die Steuerung des Verschlusses 5 von 3.

Diese Steuerung kann bei der Erfindung durch die sehr kurzen Pulse des Gating-Lasers 7 so schnell erfolgen, daß das Auslesen von mehr Bildern pro Zeit möglich ist (in 40) und dadurch ein Entfernungs- oder Reliefbild (in 6) dargestellt werden kann. Wie Fig. 9 weiter zeigt und im Zusammenhang mit Fig. 1 und 3 bereits erwähnt, ist es bei Lasern zur Entfernungsmessung bereits bekannt, daß ein Zeittaktgenerator 37 den Zeitablauf oder die Signalfolge bestimmt, in dem ein Beleuchtungslaser 1 über eine Optik 2 Licht aussendet, das reflektiert empfangen wird über eine Optik 4 in einem Sensor 3. Bekannt war auch, solche Beleuchtungslaser 1 zu takten oder zu tasten und mittels eines Halbleiters (Schalters) den Empfänger nur einzuschalten bzw. "scharf" zu schalten, wenn ein Torgenerator 38 das Empfangstor in die Schaltstellung "Offen" brachte (vgl. Fig. 8 oberer Teil).

Neu ist bei der Erfindung, daß der Halbleiter so ausgebildet ist, daß er mit Hilfe gepulsten Lichtes so steuerbar ist, daß nur dann ein Weitertransport einer zwischengespeicherten Raumladung zum Auslesen erfolgt, wenn ein solcher Gating- oder Shutting-Impuls vorliegt (vgl. Fig. 8 unterer Teil).

Die Anwendung der Erfindung ist bei einem Abstandswarnsystem und Entfernungssystem mittels Laser nach DE 36 40 449 A1 von Vorteil.

Die Anwendung bei einem automatischen Führungssystem "Prometheus" vgl. Bild der Wissenschaft 10 - 1988, S. 134 ist besonders vorteilhaft.

## Patentansprüche

1. Bildsensor auf Halbleiterbasis insbesondere in CCD-Struktur mit einem zellenförmigen oder flächenhaften (zweidimensionalen) Array und einer parallelen oder seriellen Auslesung **dadurch** **gekennzeichnet**, daß
- auf der einen Seite des Halbleiters eine Avalanchediode angeordnet ist,
- durch die ein bei Lichteinfall von außen erzeugter Photostrom verstärkt wird,
- eine Raumladung im anschließenden Halbleitergebiet erzeugt wird und ein Ladungsträgertransport zur CCD-Auslesestruktur hin erfolgt,
- und auf der Seite des Halbleiters mit der CCD-Auslesestruktur ein Kontrast- oder ein Entfernungsbild ausgegeben wird und
- daß der Sensor durch Einleiten gepulsten Lichtes in das Halbleitergebiet in dem die Raumladung erzeugt wurde, optisch so gesteuert wird, daß der Transport der Raumladung nur während des Gate-Lichtimpulses erfolgt.

2. Bildsensor nach Anspruch 1, **dadurch** **gekennzeichnet**, daß er zugleich als Verschluß ansteuerbar ist.

3. Bildsensor nach einem der vorhergehenden Ansprüche, **dadurch** **ge****kennzeichnet**, daß er in einem KFZ-Abstandswarnsystem mit Laser-Sender und -Empfänger angewandt wird.

4. Bildsensor nach Anspruch 3, **dadurch** **gekennzeichnet,** daß er in einem automatischen Fahrzeugführungssystem mit automatischer gegenseitiger Abstandseinhaltung angewandt wird.

## Claims

1. Semiconductor-based image sensor, in particular in CCD structure, with a line-like or flat (two-dimensional) array and a parallel or serial read-out, characterised in that
- an avalanche diode is arranged on one side of the semiconductor,
- by means of which diode a photocurrent produced upon the incidence of light from outside is amplified,
- a space charge is produced in the adjacent semiconductor region and a charge carrier transport to the CCD read-out structure takes place,
- and a contrast or distant image is delivered on the side of the semiconductor with the CCD read-out structure, and
- that the sensor is optically controlled through the introduction of pulsed light into the semiconductor region in which the space charge was produced such that the transport of the space charge only takes place during the gate light pulse.

2. Image sensor according to claim 1, characterised in that it can at the same time be activated as a shutter.

3. Image sensor according to any one of the preceding claims, characterised in that it is employed in a motor vehicle distance warning system with a laser transmitter and receiver.

4. Image sensor according to claim 3, characterised in that it is employed in an automatic vehicle control system with automatic mutual distance observation.

## Revendications

1. Capteur d'image à base de semi-conducteur, en particulier en structure CCD (à couplage de charge) avec un dispositif en forme de ligne ou de surface (bidimensionnel) et à lecture parallèle ou sérielle, caractérisé en ce que
- une diode à avalance est disposée d'un côté du semi-conducteur,
- cette diode amplifie un courant photoélectrique généré, en cas d'incidence de lumière de l'extérieur,
- une charge spatiale est créée de ce fait dans la zone de semi-conducteur adjacente et un transport de porteurs de charge est provoqué vers la structure de lecture CCD,
- avec délivrance d'une image de contraste ou de distance, et que,
- par introduction de lumière pulsée dans la zone de semi-conducteur dans laquelle a été créée la charge spatiale, le capteur est commandé, optiquement, de manière que le transport de la charge spatiale s'effectue seulement pendant l'impulsion lumineuse de déclenchement.

2. Capteur d'image selon la revendication 1, caractérisé en ce qu'il est susceptible d'être commandé en même temps à la façon d'un obturateur.

3. Capteur d'image selon une des revendications précédentes, caractérisé en ce qu'il est appliqué dans un système d'avertissement de distance à émetteur et récepteur laser pour véhicule automobile.

4. Capteur d'image selon la revendication 3, caractérisé en ce qu'il est appliqué dans un système automatique de guidage de véhicule avec respect automatique d'une distance entre des véhicules qui se suivent.
